# EUROPÄISCHE PATENTSCHRIFT

(11) **EP 3 574 723 B1**
(45) Veröffentlichungstag und Bekanntmachung des Hinweises auf die Patenterteilung: **14.06.2023**
(21) Anmeldenummer: 17822190.9
(22) Anmeldetag: 07.12.2017
(51) Int. Cl.: H05K 1/14, H05K 3/30, H05K 3/00, H05K 3/28

(54) **VERFAHREN ZUM MECHANISCHEN VERBINDEN VON ELEKTRONISCHEN BAUELEMENTEN UND ENTSPRECHENDE ANORDNUNG DIESER ELEKTRONISCHEN BAUELEMENTE**
METHOD FOR MECHANICALLY CONNECTING ELECTRONIC COMPONENTS AND CORRESPONDING ARRANGEMENT OF THESE ELECTRONIC COMPONENTS
PROCÉDÉ DE RACCORDEMENT MÉCANIQUE DE COMPOSANTS ÉLECTRONIQUES ET ARRANGEMENT CORRESPONDANT DESDITS COMPOSANTS ÉLECTRONIQUES

(30) Priorität: 25.01.2017 DE 102017201135
(43) Veröffentlichungstag der Anmeldung: 04.12.2019
(73) Patentinhaber: Robert Bosch GmbH, 70442 Stuttgart (DE)
(72) Erfinder: KAESS, Udo, 74399 Walheim (DE); LISKOW, Uwe, 71679 Asperg (DE); WEISS, Markus, 73760 Ostfildern (DE)
(86) Internationale Anmeldenummer: PCT/EP2017/081920
(87) Internationale Veröffentlichungsnummer: WO 2018/137827

(56) Entgegenhaltungen:
- EP-A2- 0 533 198
- WO-A1-2014/023457
- DE-A1-102011 088 969
- JP-A- 2008 270 601
- US-B1- 7 658 470

## Beschreibung

### Gebiet der Erfindung

Die Erfindung betrifft ein Verfahren zum mechanischen Verbinden eines ersten elektronischen Bauelements, insbesondere eines Leiterplattenelements, mit einem zweiten elektronischen Bauelement, insbesondere einem zweiten Leiterplattenelement, und eine Anordnung von elektronischen Bauelementen.

### Stand der Technik

Elektronische Bauelemente, wie z.B. Leiterplattenelemente, Flexfolien, Direct Bonded Copper(DBC)-Elemente und/oder Sensordome müssen mechanisch und elektrisch miteinander verbunden werden. Zur elektrischen Verbindung werden oftmals Kabelverbinder, Jumper oder ähnliches verwendet. Zur mechanischen Verbindung der beiden elektronischen Bauelemente werden oftmals Schrauben, Nieten oder ähnliches verwendet. Die Verwendung von Schrauben, Nieten oder ähnlichem führt zu mechanischen Belastungen der elektronischen Bauelemente während des Verbindungsvorgangs. Nachteilig an der Verwendung von Schrauben, Nieten oder ähnlichem zum mechanischen Verbinden ist auch, dass diese üblicherweise aus dem elektronischen Bauelement hervorstehen. Auch können bei Verwendung von metallischen Schrauben, Nieten oder ähnlichen unter ungünstigen Umständen metallische Späne entstehen, die Kurzschlüsse erzeugen können. Darüber hinaus können mechanische Spannungen entstehen, wenn die beiden elektronischen Bauelemente sich auf unterschiedlichen Höhenniveaus befinden.

Im Stand der Technik ist eine Anordnung von elektronischen Bauelementen, umfassend ein als Leiterplatte ausgebildetes erstes elektronisches Bauelement und ein als Leiterplatte ausgebildetes zweites elektronisches Bauelement beispielsweise aus der DE 10 2011 088696 A1 bekannt. Weitere Anordnungen sind aus der WO 2014/023457 A1, der US 7 658 470 B1 und der EP 0533 198 A2 bekannt.

Aus der JP 2008 270601 A ist ein Verfahren zum mechanischen Verbinden eines ersten elektronischen Bauelements mit einem zweiten elektronischen Bauelement bekannt, bei dem das erste elektronische Bauelement über dem zweiten elektronischen Bauelement derart angeordnet wird, dass eine zweite Durchgangsöffnung des zweiten elektronischen Bauelements zumindest teilweise unterhalb einer ersten Durchgangsöffnung des ersten elektronischen Bauelements angeordnet ist und eine Vergussmasse in die erste Durchgangsöffnung und in die zweite Durchgangsöffnung eingebracht wird.

### Offenbarung der Erfindung

### Vorteile der Erfindung

Ausführungsformen der vorliegenden Erfindung können in vorteilhafter Weise ermöglichen, zwei elektronische Bauelemente technisch einfach und frei von mechanischen Spannungen miteinander zu verbinden.

Gemäß einem ersten Aspekt der Erfindung wird Verfahren zum mechanischen Verbinden eines ersten elektronischen Bauelements, insbesondere eines Leiterplattenelements, mit einem zweiten elektronischen Bauelement, insbesondere einem zweiten Leiterplattenelement, vorgeschlagen, wobei das erste elektronische Bauelement eine erste Durchgangsöffnung in eine erste Richtung aufweist und das zweite elektronische Bauelement eine zweite Durchgangsöffnung oder ein Sackloch in die erste Richtung aufweist, wobei das Verfahren folgende Schritte umfasst: Anordnen und Ausrichten des ersten elektronischen Bauelements in der ersten Richtung über dem zweiten elektronischen Bauelement derart, dass die zweite Durchgangsöffnung oder das Sackloch in der ersten Richtung zumindest teilweise unterhalb der ersten Durchgangsöffnung angeordnet ist; Einbringen einer Vergussmasse in die erste Durchgangsöffnung und in die zweite Durchgangsöffnung oder in die erste Durchgangsöffnung und in das Sackloch; und Aushärten der Vergussmasse zum Arretieren des ersten elektronischen Bauelements in Bezug auf das zweite elektronische Bauelement. Erfindungsgemäß umfasst das Verfahren die folgenden Schritte: Aufbringen eines die erste Durchgangsöffnung umlaufenden Dam-Materials auf eine erste von dem zweiten elektronischen Bauelement abgewandte Seite des ersten elektronischen Bauelements und Aufbringen eines Fill-Materials als Vergussmasse auf den vom Dam-Material umschlossenen Teil der ersten Seite des ersten elektronischen Bauelements derart, dass das Fill-Material in die erste Durchgangsöffnung und in die zweite Durchgangsöffnung oder in das Sackloch eingebracht wird.

Zudem kann in der Regel das Vergussmaterial weitere Elemente, z.B. weitere elektronische Bauelemente, die auf einem der beiden elektronischen Bauelementen angeordnet sind, bedecken und diese gegen die Umgebung (z.B. eine Ölumgebung) isolieren. Das Dam-Material kann in der Regel hochviskos oder thixotrop sein, so dass das Dam-Material vor oder beim Aushärten nicht verläuft. Das Fill-Material kann in der Regel niedrigviskos sein, um Kavitäten und Spalte sicher zu füllen.

Ein Vorteil hiervon ist, dass die beiden elektronischen Bauelemente typischerweise technisch einfach und frei von mechanischen Spannungen miteinander verbunden werden. Da keine Schraube, Niet oder ähnliches zum mechanischen Verbinden der beiden elektronischen Bauelemente verwendet wird, entstehen in der Regel während des mechanischen Verbindens keine mechanischen Spannungen in den elektronischen Bauelementen.

Gemäß einem zweiten Aspekt der Erfindung wird eine Anordnung von elektronischen Bauelementen vorgeschlagen, umfassend ein erstes elektronisches Bauelement, insbesondere ein erstes Leiterplattenelement, und ein zweites elektronisches Bauelement, insbesondere eine zweites Leiterplattenelement, wobei das erste elektronische Bauelement eine erste Durchgangsöffnung in eine erste Richtung aufweist und das zweite elektronische Bauelement eine zweite Durchgangsöffnung oder ein Sackloch in die erste Richtung aufweist, wobei das zweite elektronische Bauelement derart in der ersten Richtung unterhalb des ersten elektronischen Bauelements angeordnet ist, dass die zweite Durchgangsöffnung oder das Sackloch in der ersten Richtung zumindest teilweise unterhalb der ersten Durchgangsöffnung angeordnet ist, wobei eine einstückige Vergussmasse zum Verbinden des ersten elektronischen Bauelements mit dem zweiten elektronischen Bauelement in der ersten Durchgangsöffnung und in der zweiten Durchgangsöffnung oder dem Sackloch angeordnet ist. Erfindungsgemäß ist die erste Durchgangsöffnung umlaufendes Dam-Materials auf eine erste von dem zweiten elektronischen Bauelement abgewandte Seite des ersten elektronischen Bauelements aufgebracht ist und ein Fill-Materials als Vergussmasse auf den vom Dam-Material umschlossenen Teil der ersten Seite des ersten elektronischen Bauelements derart aufgebracht, dass das Fill-Material in die erste Durchgangsöffnung und in die zweite Durchgangsöffnung oder in das Sackloch eingebracht ist. Das Fill-Material kann in der Regel niedrigviskos sein, um Kavitäten und Spalte sicher zu füllen.

Ein Vorteil hiervon ist, dass die beiden elektronischen Bauelemente typischerweise technisch einfach und frei von mechanischen Spannungen miteinander verbunden sind. Da keine Schraube, Niet oder ähnliches zum mechanischen Verbinden der beiden elektronischen Bauelemente verwendet wurde, entstehen in der Regel während des mechanischen Verbindens keine mechanischen Spannungen in den elektronischen Bauelementen.

Ideen zu Ausführungsformen der vorliegenden Erfindung können unter anderem als auf den nachfolgend beschriebenen Gedanken und Erkenntnissen beruhend angesehen werden.

Gemäß einer Ausführungsform wird das erste elektronische Bauelement derart in der ersten Richtung oberhalb des zweiten elektronischen Bauelements angeordnet, dass - die zweite Durchgangsöffnung oder das Sackloch in der ersten Richtung vollständig unterhalb der ersten Durchgangsöffnung oder - die erste Durchgangsöffnung in der ersten Richtung vollständig oberhalb der zweiten Durchgangsöffnung oder des Sacklochs angeordnet ist. Ein Vorteil hiervon ist, dass in der Regel die Vergussmasse besonders einfach in die erste Durchgangsöffnung und die zweite Durchgangsöffnung bzw. das Sackloch gelangt. Hierdurch wird üblicherweise eine besonders feste mechanische Verbindung zwischen den beiden elektronischen Bauelementen erreicht.

Gemäß einer Ausführungsform weisen die erste Durchgangsöffnung und die zweite Durchgangsöffnung oder das Sackloch jeweils eine im Querschnitt senkrecht zur ersten Richtung elliptische Form, insbesondere kreisförmige Form, auf, wobei das erste elektronische Bauelement derart zu dem zweiten elektronischen Bauelement ausgerichtet wird, dass die erste Durchgangsöffnung koaxial zu der zweiten Durchgangsöffnung oder koaxial zu dem Sackloch ausgerichtet ist. Vorteilhaft hieran ist, dass die Vergussmasse technisch besonders einfach in die erste Durchgangsöffnung und die zweite Durchgangsöffnung bzw. das Sackloch gelangt. Zudem wird hierdurch in der Regel eine eindeutige bzw. vorgegebene Position der beiden elektronischen Bauelemente zueinander erreicht.

Gemäß einer Ausführungsform umfasst das Verfahren ferner folgenden Schritt: elektrisches Verbinden des ersten elektronischen Bauelements mit dem zweiten elektronischen Bauelement an einer Stelle, die sich maximal ca. 0,75 mm, insbesondere maximal ca. 0,55 mm, von der ersten Durchgangsöffnung, der zweiten Durchgangsöffnung und/oder dem Sackloch befindet. Ein Vorteil hiervon ist, dass auch bei zueinander unterschiedlichen Wärmeausdehnungskoeffizienten der beiden elektrischen Bauelemente in der Regel im Wesentlichen keine oder nur sehr geringe mechanische Kräfte auf die Stelle der elektrischen Verbindung wirken.

Gemäß einer Ausführungsform ist die zweite Durchgangsöffnung oder das Sackloch in der ersten Richtung vollständig unterhalb der ersten Durchgangsöffnung oder die erste Durchgangsöffnung in der ersten Richtung vollständig oberhalb der zweiten Durchgangsöffnung oder des Sacklochs angeordnet. Ein Vorteil hiervon ist, dass in der Regel die Vergussmasse besonders einfach in die erste Durchgangsöffnung und die zweite Durchgangsöffnung bzw. das Sackloch gelangt. Hierdurch ist üblicherweise eine besonders feste mechanische Verbindung zwischen den beiden elektronischen Bauelementen vorhanden.

Gemäß einer Ausführungsform ist auf einer dem ersten elektronischen Bauelement abgewandten Seite des zweiten elektronischen Bauelements ein Teil der Vergussmasse angeordnet. Ein Vorteil hiervon ist, dass in der Regel mittels der Vergussmasse technisch einfach Höhenunterschiede ausgeglichen werden können. Zudem treten hierdurch typischerweise im Wesentlichen keine mechanischen Spannungen zwischen den beiden elektronischen Bauelementen auf. Vorteilhaft hieran ist auch, dass die beiden elektronischen Bauelemente in der Regel durch die Vergussmasse gleichzeitig miteinander mechanisch verbunden und an einem weiteren Element (z.B. einem Kühlkörper 70 oder einer Kühlplatte) befestigt werden können. Hierdurch sinkt in der Regel der Herstellungsaufwand.

Gemäß einer Ausführungsform weisen die erste Durchgangsöffnung und die zweite Durchgangsöffnung oder das Sackloch jeweils eine im Querschnitt senkrecht zur ersten Richtung elliptische Form, insbesondere kreisförmige Form, auf, wobei die erste Durchgangsöffnung koaxial zu der zweiten Durchgangsöffnung oder koaxial zu dem Sackloch ausgerichtet ist. Vorteilhaft hieran ist, dass die Vergussmasse technisch besonders einfach in die erste Durchgangsöffnung und die zweite Durchgangsöffnung bzw. das Sackloch gelangt. Zudem sind hierdurch die beiden elektronischen Bauelemente in der Regel in einer eindeutigen bzw. vorgegebenen Position zueinander arretiert bzw. aneinander befestigt.

Gemäß einer Ausführungsform ist die Vergussmasse teilweise zwischen dem ersten elektronischen Bauelement und dem zweiten elektronischen Bauelement zur flächigen Verbindung des ersten elektronischen Bauelements mit dem zweiten elektronischen Bauelement angeordnet ist. Hierdurch besteht eine besonders sichere flächige Verbindung zwischen den beiden elektronischen Bauelementen.

Das erste elektronische Bauelement und das zweite elektronische Bauelement können jeweils in der Regel insbesondere ein Leiterplattenelement sein oder ein Element, das auf einem Leiterplattenelement angeordnet bzw. befestigt wird.

Es ist üblicherweise auch möglich, mehr als zwei elektronische Bauelemente bzw. Leiterplattenelemente (z.B. drei, vier oder mehr als vier) miteinander auf die beschriebene Weise zu verbinden.

Es wird darauf hingewiesen, dass einige der möglichen Merkmale und Vorteile der Erfindung hierin mit Bezug auf unterschiedliche Ausführungsformen der Anordnung von elektronischen Bauelementen bzw. des Verfahrens zum mechanischen Verbinden beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine Querschnittsansicht einer nicht zur Erfindung gehörigen, beispielhaftenAnordnung von elektronischen Bauelementen;
- Fig. 2 zeigt: eine Querschnittsansicht einer zweiten Ausführungsform der erfindungsgemäßen Anordnung von elektronischen Bauelementen;
- Fig. 3 zeigt: eine Querschnittsansicht einer dritten Ausführungsform der erfindungsgemäßen Anordnung von elektronischen Bauelementen; und
- Fig. 4 zeigt: eine Querschnittsansicht einer vierten Ausführungsform der erfindungsgemäßen Anordnung von elektronischen Bauelementen.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

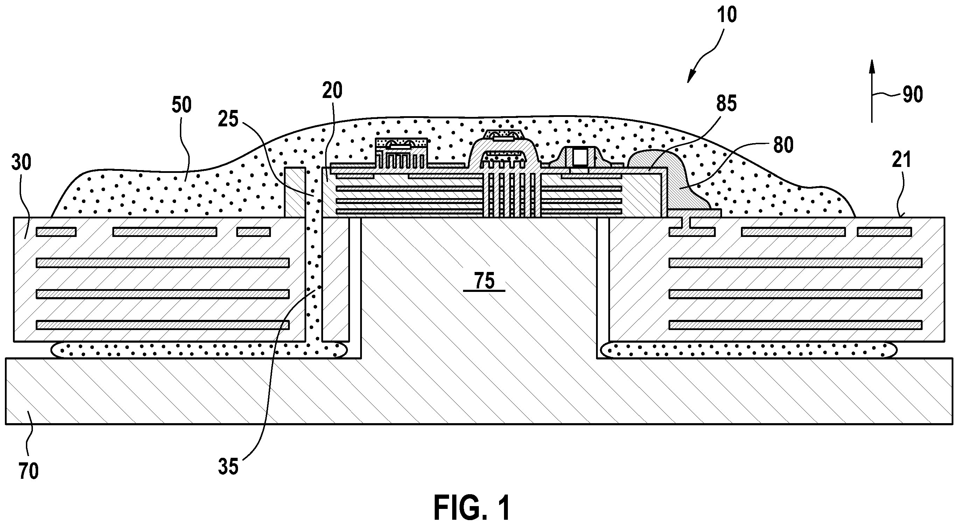

Fig. 1 zeigt eine Querschnittsansicht einer nicht zur Erfindung gehörigen, beispielhaften Anordnung 10 von elektronischen Bauelementen 20, 30. Die Anordnung 10 umfasst ein erstes elektronisches Bauelement 20, nämlich ein erstes Leiterplattenelement, und ein zweites elektronische Bauelement 30, nämlich ein zweites Leiterplattenelement. Das erste bzw. zweite Leiterplattelement kann jeweils ein starres printed circuit board (PCB), ein flexibles printed circuit board (PCB), eine Flexfolie, direct bonded copper (DBC), eine flexible Leiterplatte (FPC), ein Sensor bzw. ein Sensordom oder ähnliches sein.

Die erste Leiterplatte ist über zwei Lötstellen 80, 81 elektrisch mit der zweiten Leiterplatte verbunden. Vorstellbar ist auch, dass die beiden Leiterplattenelemente nur über eine Lötstelle, drei Lötstellen oder mehr als drei Lötstellen miteinander elektrisch verbunden sind. Die erste Leiterplatte weist eine erste Durchgangsöffnung 25 auf. Die erste Durchgangsöffnung 25 erstreckt sich in die erste Richtung 90. Die erste Richtung 90 verläuft in Fig. 1 von unten nach oben. Die zweite Leiterplatte weist eine zweite Durchgangsöffnung 35 auf. Die zweite Durchgangsöffnung 35 verläuft ebenfalls in die erste Richtung 90. Die beiden Durchgangsöffnungen 25, 35 weisen einen gleichgroßen Querschnitt senkrecht zur ersten Richtung 90 auf. Vorstellbar ist auch, dass die Querschnitte unterschiedlich groß sind. Der Querschnitt senkrecht zur ersten Richtung 90 kann ellipsenförmig, insbesondere kreisförmig, rechteckig, insbesondere quadratisch, sein. Andere Querschnitte sind vorstellbar.

Das erste Leiterplattenelement ist in der ersten Richtung 90 oberhalb des zweiten Leiterplattenelements angeordnet. Das erste Leiterplattenelement ist auf einem mittig angeordneten Vorsprung eines Kühlkörpers 70 (sogenannter Kühlbalkon 75) angeordnet. Das zweite Leiterplattenelement befindet sich auf einem Teil der Vergussmasse 50, die sich wiederum teilweise auf dem Kühlkörper 70 befindet.

Die Leiterplattenelemente sind derart zueinander ausgerichtet, dass sich die erste Durchgangsöffnung 25 oberhalb der zweiten Durchgangsöffnung 35 befindet. Wesentlich ist, dass sich die zweite Durchgangsöffnung 35 zumindest teilweise unterhalb der ersten Durchgangsöffnung 25 befindet, so dass Vergussmasse 50 aus der ersten Durchgangsöffnung 25 entlang der ersten Richtung 90 in die zweite Durchgangsöffnung 35 gelangen kann.

Die Gravitation verläuft üblicherweise in Fig. 1 von oben nach unten.

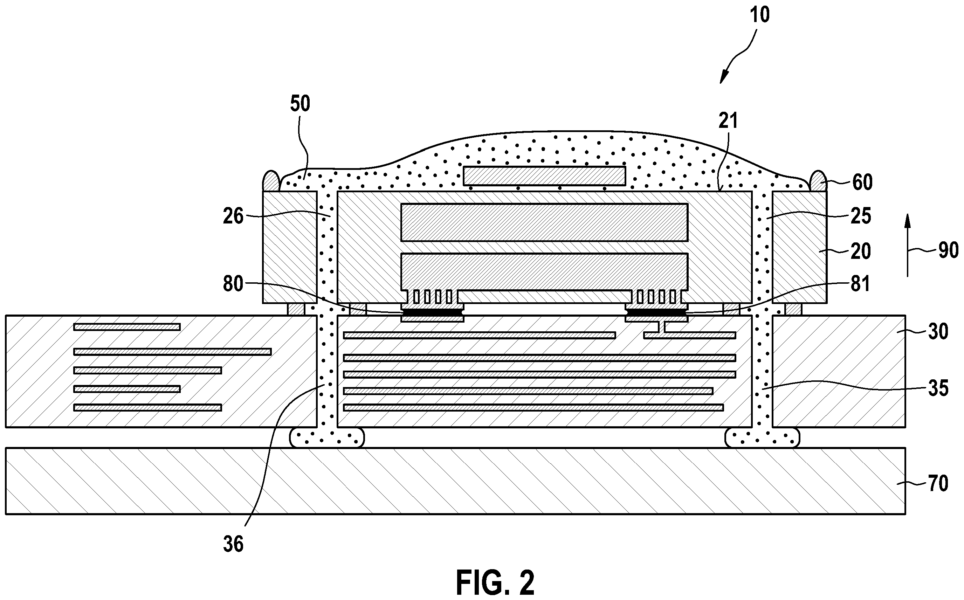

Das Vergussmaterial wird auf einen Teil einer ersten Seite 21 des ersten Leiterplattenelements aufgebracht. Die erste Seite 21 des ersten Leiterplattenelements ist dem zweiten Leiterplattenelement abgewandt. In Fig. 2 ist die erste Seite 21 des ersten Leiterplattenelementes die obere Seite.

Das Vergussmaterial ist fließfähig. Das Vergussmaterial dringt somit in die erste Durchgangsöffnung 25 bzw. wird in diese eingebracht und folglich in die zweite Durchgangsöffnung 35. Bei der in Fig. 1 gezeigten Anordnung bedeckt die Vergussmasse 50 die erste Seite 21 des ersten Leiterplattenelements vollständig. Die auf der ersten Seite 21 des ersten Leiterplattenelements angeordneten weiteren Elemente werden von der Vergussmasse 50 gegen die Umwelt isoliert. Auch die Lötstelle 80 zwischen der außenliegenden Metallisierung 85 des ersten Leiterplattenelements und dem zweiten Leiterplattenelement zum elektrischen Verbinden der beiden Leiterplattenelemente wird von der Vergussmasse 50 vollständig bedeckt. Die Vergussmasse 50 befindet sich ebenfalls teilweise zwischen dem zweiten Leiterplattenelement und der Kühlkörper 70. Hierdurch wird ein Höhenunterschied zwischen dem zweiten Leiterplattenelement und dem Kühlkörper 70 ausgeglichen. Zudem wird das zweite Leiterplattenelement hierdurch an dem Kühlkörper 70 befestigt.

Es können anwendungsspezifische Leiterplattenelement ausgewählt und miteinander kombiniert werden, z.B. eine lokal benötigte Leiterplatte mit 8 Lagen, während die Haupt-Leiterplatte nur 4 Lagen hat und somit kostengünstiger ist. Auch unterschiedliche Dicken der Leiterplattenelemente können durch die Vergussmasse 50 ausgeglichen werden. So haben Leiterplattenelemente üblicherweise eine Dicke von ca. 1, 6 mm ± 0,15 mm.

Auch unterschiedliche Höhen der Kupferbahnen können durch die Vergussmasse 50 ausgeglichen werden. Z.B. kann eine Haupt-Leiterplatte 35 µm Kupferbahnen und eine aufgeklebte Hochstrom-Leiterplatte hat 105 µm Kupferbahnen haben. Ebenso können Spalten zwischen dem ersten Leiterplattenelement und dem zweiten Leiterplattenelementen durch die Vergussmasse 50 ausgefüllt werden.

Die Vergussmasse 50 kann Epoxidharz, Polyurethan, Acrylat und/oder Silikon sein oder umfassen.

Nachdem die Vergussmasse 50 in die zweite Durchgangsöffnung 35 gelangt ist und an weitere gewünschte Stellen, wird die Vergussmasse 50 ausgehärtet. Dies wird z.B. durch Erwärmen bzw. Erhitzen durchgeführt.

Die erste Durchgangsöffnung 25 ist fluchtend zur zweiten Durchgangsöffnung 35 ausgerichtet. Auch vorstellbar ist, dass die erste Durchgangsöffnung 25 einen (kleinen) Versatz zu der zweiten Durchgangsöffnung 35 aufweist. Die erste Durchgangsöffnung 25 und die zweite Durchgangsöffnung 35 sind jeweils vollständig mit Vergussmasse 50 ausgefüllt.

Fig. 2 zeigt eine Querschnittsansicht einer ersten Ausführungsform der erfindungsgemäßen Anordnung 10 von elektronischen Bauelementen 20, 30. Hierbei weist das erste elektronische Bauelement 20, nämlich das erste Leiterplattenelement, eine geringere Breite (in Fig. 2 von links nach rechts verlaufend) auf als das zweite elektronische Bauelement 30, nämlich das zweite Leiterplattenelement. Die beiden Leiterplattenelemente sind über zwei erste Durchgangsöffnungen 25, 26 und zwei zweite Durchgangsöffnungen 35, 36 miteinander verbunden. In allen Durchgangsöffnungen 25, 26, 35, 36 ist die zusammenhängende Vergussmasse 50 vorhanden. Alle Durchgangsöffnungen 25, 26, 35, 36 sind vollständig mit Vergussmasse 50 bzw. dem Vergussmaterial gefüllt. Das zweite Leiterplattenelement liegt nicht direkt bzw. unmittelbar auf dem Kühlkörper 70 auf, sondern ein Teil der Vergussmasse 50 befindet sich dazwischen.

Auf die erste Seite 21 des ersten Leiterplattenelements wird zunächst teilweise eine die beiden ersten Durchgangsöffnungen 25, 26 bzw. die beiden oberen Ausgänge der beiden ersten Durchgangsöffnungen 25, 26 umlaufende Schicht aus Dam-Material 60 aufgebracht. Das Dam-Material 60 ist im Wesentlichen nicht fließfähig und bleibt an der aufgebrachten Stelle. Anschließend wird ein Fill-Material, das vor dem Aushärten fließfähig ist, als Vergussmaterial auf den von dem Dam-Material 60 umgegebenen Teil der ersten Seite 21 des ersten Leiterplattenelements aufgebracht. Das fließfähige Fill-Material fließt in die ersten Durchgangsöffnungen 25, 26 (es kann auch alternativ direkt in diese eingebracht werden) und in die zweiten Durchgangsöffnungen 35, 36. Teilweise fließt es auch in den Bereich zwischen dem ersten Leiterplattenelement und dem zweiten Leiterplattenelement. Ebenso fließt es in den Bereich zwischen dem zweiten Leiterplattenelement und dem Kühlkörper 70.

In Fig. 2 sind außer dem Dam-Material 60 auf der ersten Seite 21 des ersten Leiterplattenelements keine Fließbegrenzungseinrichtungen gezeigt, die verhindern, dass das Fill-Material bzw. Vergussmaterial sich weiter als in Fig. 2 gezeigt ausbreitet bzw. fließt.

Zwischen den beiden ersten Durchgangslöchern bzw. den zweiten Durchgangslöchern sind zwei Lötstellen 80, 81 zur elektrischen Verbindung der beiden Leiterplattenelemente miteinander angeordnet. Die ersten Durchgangsöffnungen 25, 26 sind jeweils fluchtend zur jeweiligen zweiten Durchgangsöffnung 35, 36 ausgerichtet.

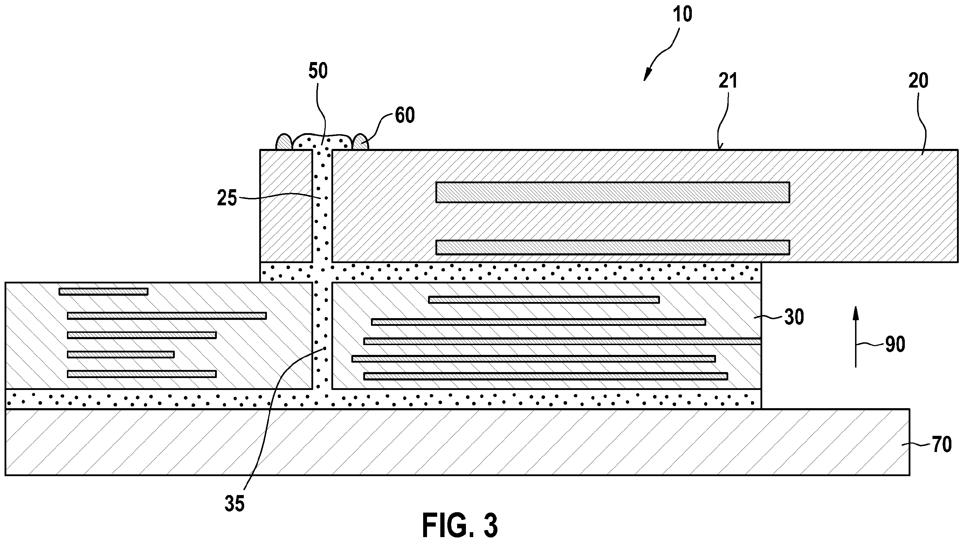

Fig. 3 zeigt eine Querschnittsansicht einer zweiten Ausführungsform der erfindungsgemäßen Anordnung 10 von elektronischen Bauelementen 20, 30. Hierbei sind die beiden elektronischen Bauelemente 20, 30 bzw. Leiterplattenelemente gleichbreit und versetzt zueinander in der ersten Richtung 90 übereinander angeordnet. Die erste Durchgangsöffnung 25 weist im Querschnitt senkrecht zur ersten Richtung 90 den gleichen Durchmesser auf wie die zweite Durchgangsöffnung 35 im Querschnitt senkrecht zur ersten Richtung 90. Die erste Durchgangsöffnung 25 ist fluchtend zur zweiten Durchgangsöffnung 35 ausgerichtet.

Im überlappenden Bereich zwischen den beiden Leiterplattenelementen ist ein Teil der Vergussmasse 50 zwischen den beiden Leiterplattenelementen angeordnet. Zudem ist im gesamten Bereich zwischen dem zweiten Leiterplattenelement und dem Kühlkörper 70 ein Teil der Vergussmasse 50 angeordnet.

In Fig. 3 sind außer dem Dam-Material 60 auf der ersten Seite 21 des ersten Leiterplattenelements keine Fließbegrenzungseinrichtungen gezeigt, die verhindern, dass das Fill-Material bzw. Vergussmaterial sich weiter als in Fig. 3 gezeigt ausbreitet bzw. fließt.

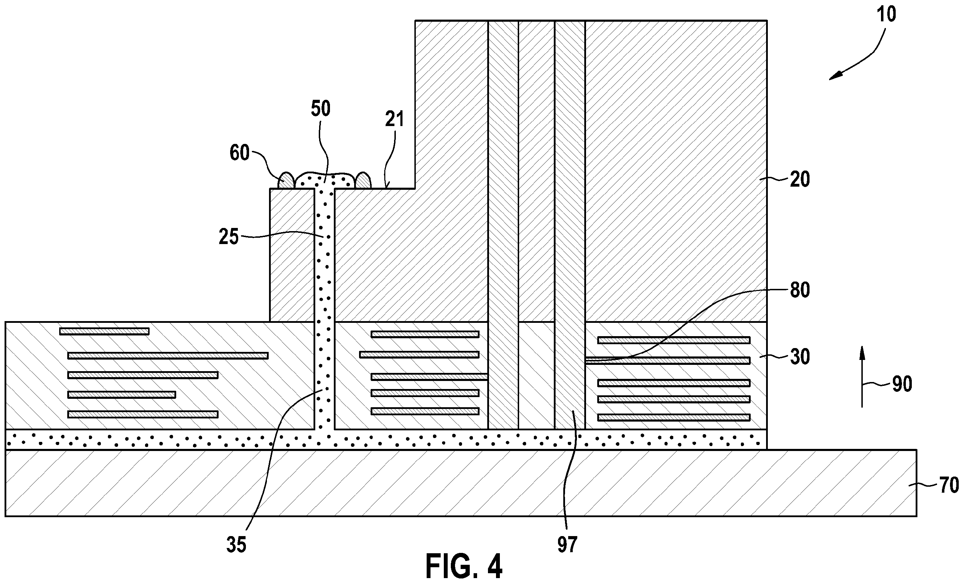

Fig. 4 zeigt eine Querschnittsansicht einer dritten Ausführungsform der erfindungsgemäßen Anordnung 10 von elektronischen Bauelementen 20, 30. Das erste elektronische Bauelement 20 ist hier ein Sensordom. Das zweite elektronische Bauelement 30 ist ein zweites Leiterplattenelement. Der Sensordom weist einen Lötpin 97 auf, der in das zweite Leiterplattenelement eingesteckt ist. Der Lötpin 97 ist über eine Lötstelle 80, 81 mit dem zweiten Leiterplattenelement (hier ein printed circuit board; PCB) elektrisch verbunden.

Zwischen dem zweiten Leiterplattenelement und dem Kühlkörper 70 ist ein Teil der Vergussmasse 50 angeordnet. Ein Dam-Material 60 wird um die Eingangsöffnung der ersten Durchgangsöffnung 25 auf eine erste Seite 21 des Sensordoms aufgebracht, welche von dem zweiten Leiterplattenelement abgewandt ist. Danach wird die Vergussmasse 50 bzw. das Fill-Material auf den Teil der ersten Seite 21 des Sensordoms aufgebracht, der von dem Dam-Material 60 umschlossen ist. Das Fill-Material fließt durch die erste Durchgangsöffnung 25 in die zweite Durchgangsöffnung 35 und auf die von dem Sensordom abgewandte Seite 21 des zweiten Leiterplattenelements.

In Fig. 4 sind außer dem Dam-Material 60 auf der ersten Seite 21 des ersten Leiterplattenelements keine Fließbegrenzungseinrichtungen gezeigt, die verhindern, dass das Fill-Material bzw. Vergussmaterial sich weiter als in Fig. 4 gezeigt ausbreitet bzw. fließt.

Der Sensordom bzw. die elektrische Verbindungen des Sensordoms sind durch die Vergussmasse 50 unterhalb des zweiten Leiterplattenelements elektrisch gegenüber dem Kühlkörper 70 isoliert.

Anstelle einer zweiten Durchgangsöffnung 35, 36 kann bei allen gezeigten Ausführungsformen das zweite elektronische Bauelement 20, 30 bzw. das zweite Leiterplattenelement ein Sackloch aufweisen, das nach oben hin bzw. in Richtung des ersten elektronischen Bauelements 20 bzw. des ersten Leiterplattenelements bzw. der ersten Durchgangsöffnung 25 offen ist.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Verfahren zum mechanischen Verbinden eines ersten elektronischen Bauelements (20), insbesondere eines Leiterplattenelements, mit einem zweiten elektronischen Bauelement (30), insbesondere einem zweiten Leiterplattenelement, wobei das erste elektronische Bauelement (20) eine erste Durchgangsöffnung (25, 26) in eine erste Richtung (90) aufweist und das zweite elektronische Bauelement (30) eine zweite Durchgangsöffnung (35, 36) oder ein Sackloch in die erste Richtung (90) aufweist, wobei das Verfahren folgende Schritte umfasst:
Anordnen und Ausrichten des ersten elektronischen Bauelements (20) in der ersten Richtung (90) über dem zweiten elektronischen Bauelement (30) derart, dass die zweite Durchgangsöffnung (35, 36) oder das Sackloch in der ersten Richtung (90) zumindest teilweise unterhalb der ersten Durchgangsöffnung (25, 26) angeordnet ist;
Einbringen einer Vergussmasse (50) in die erste Durchgangsöffnung (25, 26) und in die zweite Durchgangsöffnung (35, 36) oder in die erste Durchgangsöffnung (25, 26) und in das Sackloch; und
Aushärten der Vergussmasse (50) zum Arretieren des ersten elektronischen Bauelements (20) in Bezug auf das zweite elektronische Bauelement (30), **gekennzeichnet durch** die folgenden Schritte:
Aufbringen eines die erste Durchgangsöffnung (25, 26) umlaufenden Dam-Materials (60) auf eine erste von dem zweiten elektronischen Bauelement (30) abgewandte Seite (21) des ersten elektronischen Bauelements (20) und
Aufbringen eines Fill-Materials als Vergussmasse (50) auf den vom Dam-Material (60) umschlossenen Teil der ersten Seite (21) des ersten elektronischen Bauelements (20) derart, dass das Fill-Material in die erste Durchgangsöffnung (25, 26) und in die zweite Durchgangsöffnung (35, 36) oder in das Sackloch eingebracht wird.

2. Verfahren nach Anspruch 1, wobei
das erste elektronische Bauelement (20) derart in der ersten Richtung (90) oberhalb des zweiten elektronischen Bauelements (30) angeordnet wird, dass
- die zweite Durchgangsöffnung (35, 36) oder das Sackloch in der ersten Richtung (90) vollständig unterhalb der ersten Durchgangsöffnung (25, 26)
oder
- die erste Durchgangsöffnung (25, 26) in der ersten Richtung (90) vollständig oberhalb der zweiten Durchgangsöffnung (35, 36) oder des Sacklochs angeordnet ist.

3. Verfahren nach Anspruch 1 oder 2, wobei
die erste Durchgangsöffnung (25, 26) und die zweite Durchgangsöffnung (35, 36) oder das Sackloch jeweils eine im Querschnitt senkrecht zur ersten Richtung (90) elliptische Form, insbesondere kreisförmige Form, aufweisen, wobei das erste elektronische Bauelement (20) derart zu dem zweiten elektronischen Bauelement (30) ausgerichtet wird, dass die erste Durchgangsöffnung (25, 26) koaxial zu der zweiten Durchgangsöffnung (35, 36) oder koaxial zu dem Sackloch ausgerichtet ist.

4. Verfahren nach einem der vorhergehenden Ansprüche, ferner folgenden Schritt umfassend:
elektrisches Verbinden des ersten elektronischen Bauelements (20) mit dem zweiten elektronischen Bauelement (30) an einer Stelle, die sich maximal ca. 0,75 mm, insbesondere maximal ca. 0,55 mm, von der ersten Durchgangsöffnung (25, 26), der zweiten Durchgangsöffnung (35, 36) und/oder dem Sackloch befindet.

5. Anordnung (10) von elektronischen Bauelementen (20, 30), umfassend ein erstes elektronisches Bauelement (20), insbesondere ein erstes Leiterplattenelement, und ein zweites elektronisches Bauelement (30), insbesondere eine zweites Leiterplattenelement,
wobei
das erste elektronische Bauelement (20) eine erste Durchgangsöffnung (25, 26) in eine erste Richtung (90) aufweist und das zweite elektronische Bauelement (30) eine zweite Durchgangsöffnung (35, 36) oder ein Sackloch in die erste Richtung (90) aufweist,
wobei das zweite elektronische Bauelement (30) derart in der ersten Richtung (90) unterhalb des ersten elektronischen Bauelements (20) angeordnet ist, dass die zweite Durchgangsöffnung (35, 36) oder das Sackloch in der ersten Richtung (90) zumindest teilweise unterhalb der ersten Durchgangsöffnung (25, 26) angeordnet ist,
wobei eine einstückige Vergussmasse (50) zum Verbinden des ersten elektronischen Bauelements (20) mit dem zweiten elektronischen Bauelement (30) in der ersten Durchgangsöffnung (25, 26) und in der zweiten Durchgangsöffnung (35, 36) oder dem Sackloch angeordnet ist,
**dadurch gekennzeichnet, dass** ein die erste Durchgangsöffnung (25, 26) umlaufenden Dam-Materials (60) auf eine erste von dem zweiten elektronischen Bauelement (30) abgewandte Seite (21) des ersten elektronischen Bauelements (20) aufgebracht ist und
ein Fill-Materials als Vergussmasse (50) auf den vom Dam-Material (60) umschlossenen Teil der ersten Seite (21) des ersten elektronischen Bauelements (20) derart aufgebracht ist, dass das Fill-Material in die erste Durchgangsöffnung (25, 26) und in die zweite Durchgangsöffnung (35, 36) oder in das Sackloch eingebracht ist.

6. Anordnung (10) nach Anspruch 5, wobei
die zweite Durchgangsöffnung (35, 36) oder das Sackloch in der ersten Richtung (90) vollständig unterhalb der ersten Durchgangsöffnung (25, 26) oder die erste Durchgangsöffnung (25, 26) in der ersten Richtung (90) vollständig oberhalb der zweiten Durchgangsöffnung (35, 36) oder des Sacklochs angeordnet ist.

7. Anordnung (10) nach Anspruch 5 oder 6, wobei
auf einer dem ersten elektronischen Bauelement (20) abgewandten Seite des zweiten elektronischen Bauelements (30) ein Teil der Vergussmasse (50) angeordnet ist.

8. Anordnung (10) nach einem der Ansprüche 5 bis 7, wobei
die erste Durchgangsöffnung (25, 26) und die zweite Durchgangsöffnung (35, 36) oder das Sackloch jeweils eine im Querschnitt senkrecht zur ersten Richtung (90) elliptische Form, insbesondere kreisförmige Form, aufweisen, wobei die erste Durchgangsöffnung (25, 26) koaxial zu der zweiten Durchgangsöffnung (35, 36) oder koaxial zu dem Sackloch ausgerichtet ist.

9. Anordnung (10) nach einem der Ansprüche 5 bis 8, wobei
die Vergussmasse (50) teilweise zwischen dem ersten elektronischen Bauelement (20) und dem zweiten elektronischen Bauelement (30) zur flächigen Verbindung des ersten elektronischen Bauelements (20) mit dem zweiten elektronischen Bauelement (30) angeordnet ist.

## Claims

1. Method for mechanically connecting a first electronic component (20), in particular a printed circuit board element, to a second electronic component (30), in particular a second printed circuit board element, wherein the first electronic component (20) comprises a first through-opening (25, 26) in a first direction (90) and the second electronic component (30) comprises a second through-opening (35, 36) or a blind hole in the first direction (90), wherein the method comprises the following steps:
arranging and aligning the first electronic component (20) over the second electronic component (30) in the first direction (90), in such a way that the second through-opening (35, 36) or the blind hole is arranged at least partially below the first through-opening (25, 26) in the first direction (90) ;
introducing an encapsulation compound (50) into the first through-opening (25, 26) and into the second through-opening (35, 36), or into the first through-opening (25, 26) and into the blind hole; and
curing the encapsulation compound (50) in order to fix the first electronic component (20) in relation to the second electronic component (30), **characterized by** the following steps:
applying a dam material (60), which extends around the first through-opening (25, 26), onto a first side (21) of the first electronic component (20), facing away from the second electronic component (30), and
applying a fill material as an encapsulation compound (50) onto that part of the first side (21) of the first electronic component (20) which is enclosed by the dam material (60), in such a way that the fill material is introduced into the first through-opening (25, 26) and into the second through-opening (35, 36) or into the blind hole.

2. Method according to Claim 1, wherein
the first electronic component (20) is arranged above the second electronic component (30) in the first direction (90), in such a way that
- the second through-opening (35, 36) or the blind hole is arranged fully below the first through-opening (25, 26) in the first direction (90),
or
- the first through-opening (25, 26) is arranged fully above the second through-opening (35, 36) or the blind hole in the first direction (90).

3. Method according to Claim 1 or 2, wherein
the first through-opening (25, 26) and the second through-opening (35, 36) or the blind hole respectively have an elliptical shape, in particular a circular shape, in cross section perpendicularly to the first direction (90), the first electronic component (20) being aligned with respect to the second electronic component (30) in such a way that the first through-opening (25, 26) is aligned coaxially with the second through-opening (35, 36) or coaxially with the blind hole.

4. Method according to one of the preceding claims, furthermore comprising the following step:
electrically connecting the first electronic component (20) to the second electronic component (30) at a position which is located at most about 0.75 mm, in particular at most about 0.55 mm, away from the first through-opening (25, 26), the second through-opening (35, 36) and/or the blind hole.

5. Arrangement (10) of electronic components (20, 30) comprising a first electronic component (20), in particular a first printed circuit board element, and a second electronic component (30), in particular a second printed circuit board element, wherein
the first electronic component (20) comprises a first through-opening (25, 26) in a first direction (90) and the second electronic component (30) comprises a second through-opening (35, 36) or a blind hole in the first direction (90),
the second electronic component (30) being arranged below the first electronic component (20) in the first direction (90) in such a way that the second through-opening (35, 36) or the blind hole is arranged at least partially below the first through-opening (25, 26) in the first direction (90),
a monobloc encapsulation compound (50) for connecting the first electronic component (20) to the second electronic component (30) being arranged in the first through-opening (25, 26) and in the second through-opening (35, 36) or the blind hole, **characterized in that** a dam material (60), which extends around the first through-opening (25, 26), is applied onto a first side (21) of the first electronic component (20), facing away from the second electronic component (30), and
a fill material is applied as an encapsulation compound (50) onto that part of the first side (21) of the first electronic component (20) which is enclosed by the dam material (60), in such a way that the fill material is introduced into the first through-opening (25, 26) and into the second through-opening (35, 36) or into the blind hole.

6. Arrangement (10) according to Claim 5, wherein
the second through-opening (35, 36) or the blind hole is arranged fully below the first through-opening (25, 26) in the first direction (90), or the first through-opening (25, 26) is arranged fully above the second through-opening (35, 36) or the blind hole in the first direction (90).

7. Arrangement (10) according to Claim 5 or 6, wherein a part of the encapsulation compound (50) is arranged on a side of the second electronic component (30) facing away from the first electronic component (20).

8. Arrangement (10) according to one of Claims 5 to 7, wherein
the first through-opening (25, 26) and the second through-opening (35, 36) or the blind hole respectively have an elliptical shape, in particular a circular shape, in cross section perpendicularly to the first direction (90), the first through-opening (25, 26) being aligned coaxially with the second through-opening (35, 36) or coaxially with the blind hole.

9. Arrangement (10) according to one of Claims 5 to 8, wherein
the encapsulation compound (50) is arranged partially between the first electronic component (20) and the second electronic component (30) for surface connection of the first electronic component (20) to the second electronic component (30).

## Revendications

1. Procédé de liaison mécanique d'un premier composant électronique (20), notamment d'un élément de plaque conductrice avec un deuxième composant électronique (30), notamment un deuxième élément de plaque conductrice, dans lequel le premier composant électronique (20) comporte une première ouverture traversante (25, 26) pratiquée dans une première direction (90) et le deuxième composant électronique (30) comporte une deuxième ouverture traversante (35, 36) ou un trou borgne pratiqué dans la première direction (90), dans lequel le procédé comprend les étapes suivantes :
agencement du premier composant électronique (20) dans la première direction (90) au-dessus du deuxième composant électronique (30) de telle sorte que la deuxième ouverture traversante (35, 36) ou le trou borgne soit disposé dans la première direction (90) au moins en partie en dessous de la première ouverture traversante (25, 26) ;
introduction d'une masse coulée (50) dans la première ouverture traversante (25, 26) et dans la deuxième ouverture traversante (35, 36) ou dans la première ouverture traversante (25, 26) et dans le trou borgne ; et
durcissement de la masse coulée (50) afin de bloquer le premier composant électronique (20) par rapport au deuxième composant électronique (30) ;
**caractérisé par** les étapes suivantes :
application d'un matériau de barrage (60) entourant la première ouverture traversante (25, 26) sur un premier côté (21), opposé au matériau de barrage, du premier composant électronique (20) ; et
application d'un matériau de remplissage sous forme de masse coulée (50) sur la partie du premier côté (21) du premier composant électronique (20) entourée par le matériau de barrage (60) de telle sorte que le matériau de remplissage est amené dans la première ouverture traversante (25, 26) et dans la deuxième ouverture traversante (35, 36) ou dans le trou borgne.

2. Procédé selon la revendication 1, dans lequel :
le premier composant électronique (20) est disposé de telle sorte dans la première direction (90) située au-dessus du deuxième composant électronique (30) que :
- la deuxième ouverture traversante (35,36) ou le trou borgne est disposé dans la première direction (90) entièrement en dessous de la première ouverture traversante (25, 26) ; ou
- la première ouverture traversante (25, 26) est disposée dans la première direction (90) entièrement au-dessus de la deuxième ouverture traversante (35, 36) ou du trou borgne.

3. Procédé selon la revendication 1 ou 2, dans lequel : la première ouverture traversante (25, 26) et la deuxième ouverture traversante (35, 36) ou le trou borgne comportent respectivement une forme elliptique en section transversale s'étendant perpendiculairement à la première direction (90), notamment une forme circulaire, dans lequel le premier composant électronique (20) est orienté de telle sorte par rapport au deuxième composant électronique (30) que la première ouverture traversante (25, 26) est orientée dans le plan coaxial par rapport à la deuxième ouverture traversante (35, 36) ou dans le plan coaxial par rapport au trou borgne.

4. Procédé selon l'une quelconque des revendications précédentes, comprenant en outre l'étape suivante :
liaison électrique du premier composant électronique (20) avec le deuxième composant électronique (30) en un point se trouvant de façon maximale à environ 0,75 mm, notamment de façon maximale à environ 0,55 mm, par rapport à la première ouverture traversante (25, 26), à la deuxième ouverture traversante (35, 36) et/ou au trou borgne.

5. Agencement (10) de composants électroniques (20, 30), comprenant un premier composant électronique (20), notamment un premier élément de plaque conductrice et un deuxième composant électronique (30), notamment un deuxième élément de plaque conductrice, dans lequel :
le premier composant électronique (20) comporte une première ouverture traversante (25, 26) pratiquée dans une première direction (90) et le deuxième composant électronique (30) comporte une deuxième ouverture traversante (35, 36) ou un trou borgne pratiqué dans la première direction (90), dans lequel le deuxième composant électronique (30) est disposé de telle sorte dans la première direction (90) en dessous du premier composant électronique (20) que la deuxième ouverture traversante (35, 36) ou le trou borgne est disposé dans la première direction (90) au moins en partie en dessous de la première ouverture traversante (25, 26), dans lequel une masse coulée (50) d'un seul tenant et servant à relier le premier composant électronique (20) au deuxième composant électronique (30) est disposée dans la première ouverture traversante (25, 26) et dans la deuxième ouverture traversante (35, 36) ou le trou borgne ;
**caractérisé en ce qu'**un matériau de barrage (60) entourant la première ouverture traversante (25, 26) est appliqué sur un premier côté (21) du premier composant électronique (20) opposé au deuxième composant électronique (30) et un matériau de remplissage servant de masse coulée (50) est appliqué de telle sorte sur la partie du premier côté (21) du premier composant électronique (20) entourée par le matériau de barrage (60) de telle sorte que le matériau de remplissage soit introduit dans la première ouverture traversante (25, 26) et dans la deuxième ouverture traversante (35, 36) ou dans le trou borgne.

6. Agencement (10) selon la revendication 5, dans lequel :
la deuxième ouverture traversante (35, 36) ou le trou borgne est disposé dans la première direction (90) entièrement en dessous de la première ouverture traversante (25, 26) ou que la première ouverture traversante (25, 26) est disposée dans la première direction (90) entièrement au-dessus de la deuxième ouverture traversante (35, 36) ou du trou borgne.

7. Agencement (10) selon la revendication 5 ou 6, dans lequel :
une partie de la masse coulée (50) est disposée sur un côté du deuxième composant électronique (30) opposé au premier composant électronique (20).

8. Agencement (10) selon l'une quelconque des revendications 5 à 7, dans lequel :
la première ouverture traversante (25, 26) et la deuxième ouverture traversante (35, 36) ou le trou borgne comportent respectivement une forme elliptique, en section transversale, s'étendant perpendiculairement à la première direction (90), notamment circulaire, dans lequel la première ouverture traversante (25, 26) est orientée dans le plan coaxial par rapport à la deuxième ouverture traversante (35, 36) ou dans le plan coaxial par rapport au trou borgne.

9. Agencement (10) selon l'une quelconque des revendications 5 à 8, dans lequel :
la masse coulée (50) est disposée en partie entre le premier composant électronique (20) et le deuxième composant électronique (30) pour la liaison plane du premier composant électronique (20) avec le deuxième composant électronique (30).
